# EUROPEAN PATENT APPLICATION

(11) **EP 4 787 375 A1**
(43) Date of publication of application: **05.08.2026**
(21) Application number: 25220616.4
(22) Date of filing: 04.12.2025
(51) Int. Cl.: G11C 7/10, G11C 7/22

(54) **INTEGRATED CIRCUIT DEVICE INCLUDING BUFFER CIRCUIT AND OPERATING METHOD OF INTEGRATED CIRCUIT DEVICE**

(30) Priority: 03.02.2025 KR 20250012948
(71) Applicant: SK hynix Inc., Bubal-eub Icheon-si Gyeonggi-do 17336 (KR)
(72) Inventor: KWON, Han Byeol, 17336 Icheon-si, Gyeonggi-do (KR); KIM, Kyu Young, 17336 Icheon-si, Gyeonggi-do (KR); KIM, Min O, 17336 Icheon-si, Gyeonggi-do (KR); YOU, Jung Taek, 17336 Icheon-si, Gyeonggi-do (KR)
(74) Representative: Isarpatent

(57) **Abstract**

An integrated circuit device includes one or more input terminals, a buffer setting storage circuit configured to receive and store buffer setting information in response to a clock sync state signal, and one or more buffer circuits configured to be set based on the buffer setting information stored in the buffer setting storage circuit and configured to receive signals of the one or more input terminals, respectively.

## Description

### BACKGROUND

### 1. Technical Field

Various embodiments of the present disclosure relate to an integrated circuit device including a buffer circuit.

### 2. Related Art

Various integrated circuit devices may operate in synchronization with a clock signal and may support an operation at various frequencies. Memory devices may also operate in synchronization with a clock signal, and although a frequency of the clock signal is sometimes fixed, the frequency of the clock signal may change to increase performance or reduce current consumption of the memory devices during the operation.

### SUMMARY

In accordance with an embodiment of the present disclosure, an integrated circuit device includes one or more input terminals, a buffer setting storage circuit configured to receive and store buffer setting information in response to a clock sync state signal, and one or more buffer circuits configured to be set based on the buffer setting information stored in the buffer setting storage circuit and configured to receive signals of the one or more input terminals, respectively.

In accordance with an embodiment of the present disclosure, an operating method of an integrated circuit device includes changing clock frequency setting information; decoding the clock frequency setting information and generating buffer setting information; transitioning from a clock sync-on state to a clock sync-off state; and applying the buffer setting information to one or more buffer circuits in response to the transitioning.

### BRIEF DESCRIPTION OF THE DRAWINGS

FIG. 1 is a block diagram illustrating a memory device in accordance with an embodiment of the present disclosure.
FIG. 2 is a block diagram illustrating an example of an internal clock generation circuit illustrated in FIG. 1.
FIGS. 3 and 4 are timing diagrams during an operation of the internal clock generation circuit.

### DETAILED DESCRIPTION

Various embodiments of the present disclosure are directed to technology of stably changing settings of a buffer circuit during a process of changing an operating frequency of an integrated circuit device.

According to embodiments of the present disclosure, it is possible to stably change settings of a buffer circuit during a process of changing an operating frequency of an integrated circuit device.

Hereinafter, various embodiments according to the technical spirit of the present disclosure are described below with reference to the accompanying drawings.

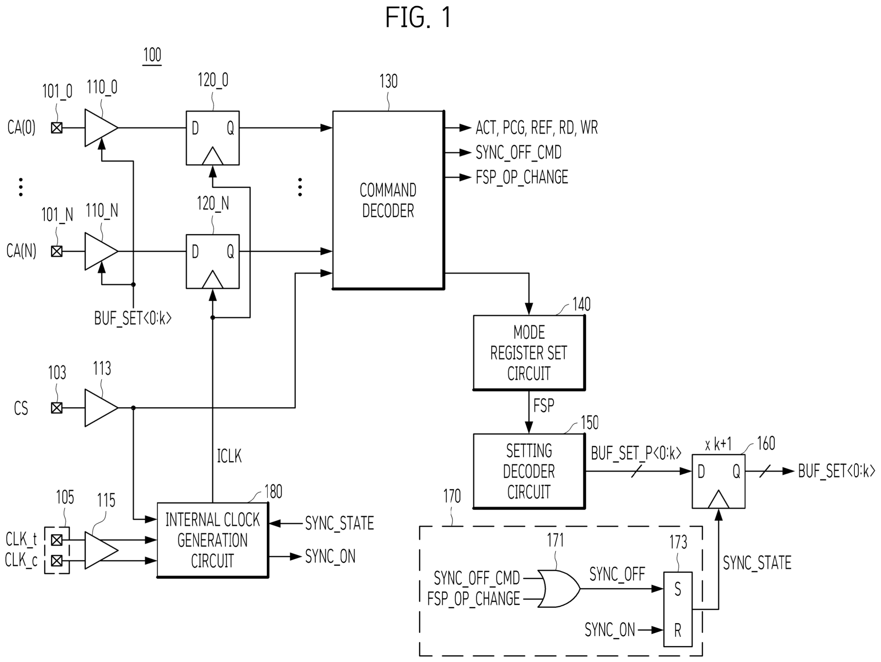

FIG. 1 is a block diagram illustrating a memory device 100 in accordance with an embodiment of the present disclosure. FIG. 1 illustrates configurations for receiving control signals in the memory device 100 and configurations related thereto.

Referring to FIG. 1, the memory device 100 includes command address input terminals 101_0 to 101_N, a chip selection signal input terminal 103, clock input terminals 105, command address buffer circuits 110_0 to 110_N, a chip selection signal buffer circuit 113, a clock buffer circuit 115, latch circuits 120_0 to 120_N, a command decoder 130, a mode register set circuit 140, a setting decoder circuit 150, a buffer setting storage circuit 160, a sync state signal generation circuit 170, and an internal clock generation circuit 180.

The command address buffer circuits 110_0 to 110_N receive command address signals CA<0:N> transmitted to the command address input terminals 101_0 to 101_N, respectively. The command address buffer circuits 110_0 to 110_N are set by buffer setting information BUF_SET<0:k>. Current usage and operating speed of the command address buffer circuits 110_0 to 110_N may change according to the buffer setting information BUF_SET<0:k>.

The chip selection signal buffer circuit 113 receives a chip selection signal CS transmitted to the chip selection signal input terminal 103.

The clock buffer circuit 115 receives clock signals CLK_t and CLK_c transmitted to the clock input terminals 105. Because the clock signals CLK_t and CLK_c are differential signals, the quantity of clock input terminals 105 is also two. However, the present disclosure is not limited thereto. The number of clock signals and clock input terminals may vary.

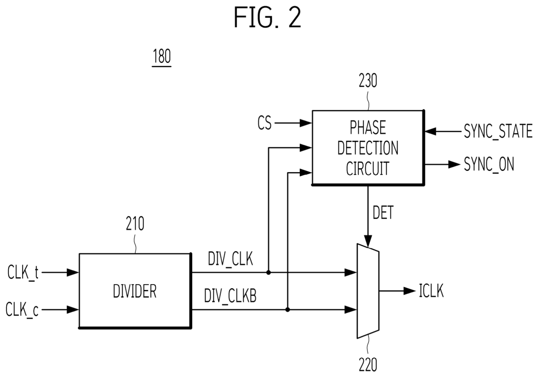

The internal clock generation circuit 180 divides the clock signals CLK_t and CLK_c received by the clock buffer circuit 115 and generates a sync-on internal clock signal ICLK. The sync-on internal clock signal ICLK refers to an internal clock signal, the rising edge of which synchronizes with an input period of the chip selection signal CS. The internal clock generation circuit 180 performs a sync-on operation using the chip selection signal CS that is activated in a sync-off state and generates a sync-on signal SYNC_ON indicating that the internal clock signal ICLK is now in a sync-on state. The internal clock generation circuit 180 is described in detail with reference to FIG. 2.

The latch circuits 120_0 to 120_N store the command address signals CA<0:N> received by the command address buffer circuits 110_0 to 110_N in synchronization with the internal clock signal ICLK. For example, each of the latch circuits 120_0 to 120_N is a D flip-flop.

The command decoder 130 decodes the command address signals CA<0:N> stored in the latch circuits 120_0 to 120_N and the chip selection signal CS to determine an operation, instructed by a memory controller to the memory device 100, and generates signals accordingly. For example, an active signal ACT is a signal for instructing an active operation, a precharge signal PCG is a signal for instructing a precharge operation, a refresh signal REF is a signal for instructing a refresh operation, a read signal RD is a signal for instructing a read operation, and a write signal WR is a signal for instructing a write operation. A clock sync-off command SYNC_OFF_CMD is a signal that is activated when there is an instruction for clock sync-off, and a frequency change signal FSP_OP_CHANGE is a signal that is activated when there is an instruction to apply a setting value according to a frequency change. The command decoder 130 controls settings of the mode register set circuit 140 according to the decoding result.

The mode register set circuit 140 stores various setting values of the memory device 100 under the control of the command decoder 130. For example, the various setting values include various voltage levels required for operations, operation timing information, latency values, and operation frequency information.

The setting decoder circuit 150 generates buffer setting information BUF_SET_P<0:k> for operating the command address buffer circuits 110_0 to 110_N in an optimal state according to frequency setting information FSP stored in the mode register set circuit 140. The frequency setting information FSP is also referred to as frequency set point information and has frequency information of the clock signals CLK_t and CLK_c inputted to the memory device 100. The setting decoder circuit 150 determines the frequency information of the clock signals CLK_t and CLK_c set according to the frequency setting information FSP and generates the optimal buffer setting information BUF_SET_P<0:k> according to the frequency information. For example, each of the command address buffer circuits 110_0 to 110_N is a differential amplifier that receives an input signal by comparing a level of the input signal with a level of a reference voltage, and it is possible to control an amount of current of the differential amplifier according to buffer setting information BUF_SET_P<0:k>. Table 1, below, is a table that summarizes the buffer setting information BUF_SET_P<0:k> and the operations of the command address buffer circuits 110_0 to 110_N according to the frequency setting information FSP. The buffer setting information BUF_SET_P<0:k> generated by the setting decoder circuit 150 is not directly reflected in the command address buffer circuits 110_0 to 110_N but is reflected in the command address buffer circuits 110_0 to 110_N through the buffer setting storage circuit 160. To distinguish the buffer setting information BUF_SET_P<0:k> generated by the setting decoder circuit 150 from the buffer setting information BUF_SET<0:k> outputted from the buffer setting storage circuit 160, the symbol "P" is added to the reference symbol "BUF_SET<0:k>".

**[Table 1]**

| FSP | BUF_SET<0:k>) | BUFFER CIRCUITS |
|---|---|---|
| High Frequency | Large amount of current | High current consumption but suitable for highspeed operation |
| Intermediate Frequency | Intermediate amount of current | Intermediate current consumption and suitable for intermediate-speed operation |
| Low Frequency | Small amount of current | Low current consumption but only suitable for low-speed operation |

The buffer setting storage circuit 160 receives and stores the buffer setting information BUF_SET_P<0:k> generated by the setting decoder circuit 150 in response to a clock sync state signal SYNC_STATE. The clock sync state signal SYNC_STATE is a signal indicating whether the internal clock signal ICLK is in the sync-on state or the sync-off state. The buffer setting storage circuit 160 receives and stores the buffer setting information BUF_SET_P<0:k> in response to the clock sync state signal SYNC_STATE transitioning from the sync-on state to the sync-off state. For example, the buffer setting storage circuit 160 includes D flip-flops. In the sync-on state, the command address signals CA<0:N> are transmitted from the memory controller to the memory device 100. When a value of the buffer setting information BUF_SET<0:k> inputted to the command address buffer circuits 110_0 to 110_N changes in the sync-on state, a sudden setting change of the command address buffer circuits 110_0 to 110_N may cause a malfunction. The buffer setting storage circuit 160 receives and stores the buffer setting information BUF_SET_P<0:k> in response to the state changing to the sync-off state. That is, the value of the buffer setting information BUF_SET<0:k> outputted from the buffer setting storage circuit 160 changes at this time. Therefore, stable operations of the command address buffer circuits 110_0 to 110_N may be guaranteed.

The sync state signal generation circuit 170 generates the clock sync state signal SYNC_STATE. For example, the sync state signal generation circuit 170 includes an OR gate 171 and an SR latch 173. The OR gate 171 activates a sync-off signal SYNC_OFF when at least one of the clock sync-off command SYNC_OFF_CMD and the frequency change signal FSP_OP_CHANGE is activated. When the clock sync-off command SYNC_OFF_CMD is activated, the internal clock signal ICLK is in the sync-off state, and when the frequency change signal FSP_OP_CHANGE is activated, the internal clock signal ICLK is also in the sync-off state. The SR latch 173 generates the clock sync state signal SYNC_STATE at a high level in response to the activation of the sync-off signal SYNC_OFF and generates the clock sync state signal SYNC_STATE at a low level in response to the activation of the sync-on signal SYNC_ON. For example, the high level of the clock sync state signal SYNC_STATE refers to the sync-off state of internal clock signal ICLK, and the low level of the clock sync state signal SYNC_STATE refers to the sync-on state of the internal clock signal ICLK.

FIG. 2 is a block diagram illustrating an example of the internal clock generation circuit 180 illustrated in FIG. 1.

Referring to FIG. 2, the internal clock generation circuit 180 includes a divider 210, a selection circuit 220, and a phase detection circuit 230.

The divider 210 divides the clock signals CLK_t and CLK_c received by the clock buffer circuit 115 and generates a divided clock signal DIV_CLK and an inverted divided clock signal DIV_CLKB. For example, the divided clock signal DIV_CLK has a frequency of half that of the clock signals CLK_t and CLK_c, and the inverted divided clock signal DIV_CLKB is a clock signal obtained by inverting the divided clock signal DIV_CLK.

The selection circuit 220 selects and outputs one of the divided clock signal DIV_CLK and the inverted divided clock signal DIV_CLKB as the sync-on internal clock signal ICLK in response to a detection signal DET.

The phase detection circuit 230 operates in the sync-off state and may determine whether the internal clock signal ICLK is in the sync-off state, using the clock sync state signal SYNC_STATE. The phase detection circuit 230 perform the sync-on operation using the chip selection signal CS that is activated in the sync-off state. The phase detection circuit 230 determines which clock signal synchronizes with the chip selection signal CS, among the divided clock signal DIV_CLK and the inverted divided clock signal DIV_CLKB, and generates the detection signal DET indicating the determination result. Then, the phase detection circuit 230 activates the sync-on signal SYNC_ON indicating that the internal clock signal ICLK is in the sync-on state.

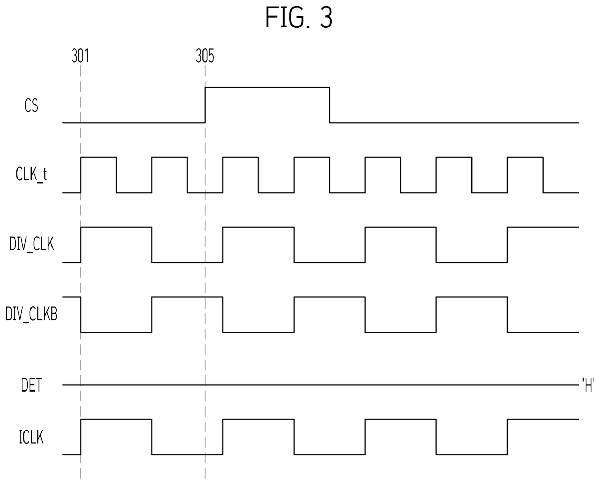

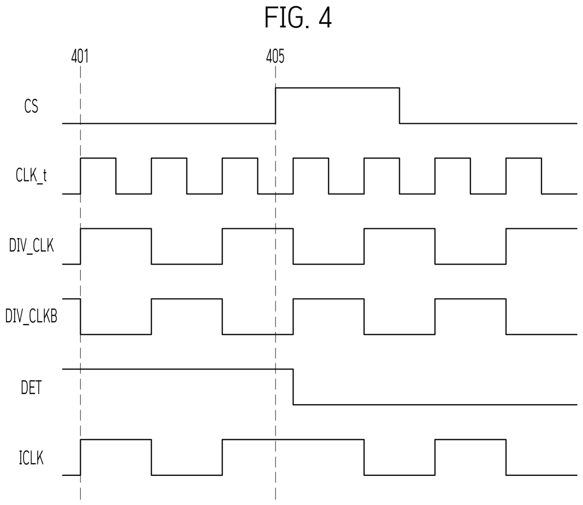

FIGS. 3 and 4 are timing diagrams during an operation of the internal clock generation circuit 180.

FIGS. 3 and 4 illustrate that the operation of the internal clock generation circuit 180 starts from the sync-off state.

Referring to FIG. 3, before time 301, the detection signal DET is checked to have a high level, and the divided clock signal DIV_CLK is selected as the internal clock signal ICLK according to the level of the detection signal DET.

At time 305, the chip selection signal CS is activated, and a rising edge of the divided clock signal DIV_CLK precedes a rising edge of the inverted divided clock signal DIV_CLKB during an activation period of the chip selection signal CS. This represents that the chip selection signal CS synchronizes with the rising edge of the divided clock signal DIV_CLK and does not synchronize with the rising edge of the inverted divided clock signal DIV_CLKB.

Because the divided clock signal DIV_CLK is a sync-on internal clock signal, the detection signal DET may continue to maintain the high level, and the divided clock signal DIV_CLK may continue to be selected as the internal clock signal ICLK. The internal clock generation circuit 180 may activate the sync-on signal SYNC_ON indicating that the sync-on operation is completely performed.

After the sync-on operation, the chip selection signal CS and the command address signals CA<0:N> is inputted in synchronization with the internal clock signal ICLK.

Referring to FIG. 4, before time 401, the detection signal DET is checked to have a high level, and the divided clock signal DIV_CLK is selected as the internal clock signal ICLK according to the level of the detection signal DET.

At time 405, the chip selection signal CS is activated, and a rising edge of the inverted divided clock signal DIV_CLKB precedes a rising edge of the divided clock signal DIV_CLK during an activation period of the chip selection signal CS. This represents that the chip selection signal CS synchronizes with the rising edge of the inverted divided clock signal DIV_CLKB and does not synchronize with the rising edge of the divided clock signal DIV_CLK.

Because the inverted divided clock signal DIV_CLKB is a sync-on internal clock signal, the detection signal DET may change from the high level to a low level, and the inverted divided clock signal DIV_CLKB may be selected and outputted as the internal clock signal ICLK. The internal clock generation circuit 180 may activate the sync-on signal SYNC_ON indicating that the sync-on operation is completely performed.

The memory device 100 does not use the clock signals CLK_t and CLK_c, which are inputted from an external device, as they are received, but uses a divided clock signal, in order to reduce current consumption. Considering this, the memory controller does not apply the chip selection signal CS and the command address signals CA<0:N> to the memory device 100 for each clock signal based on the clock signals CLK_t and CLK_c but applies the chip selection signal CS and the command address signals CA<0:N> once for each two-clock cycle based on the clock signals CLK_t and CLK_c. That is, the memory controller applies the chip selection signal CS and the command address signals CA<0:N> in synchronization with the rising edge of the divided clock signal DIV_CLK or the rising edge of the inverted divided clock signal DIV_CLKB. The clock sync-on operation is an operation to determine which clock, among the divided clock signal DIV_CLK and the inverted divided clock signal DIV CLKB, is selected as the sync-on internal clock signal and used to receive the command address signals CA<0:N>.

Referring back to FIGS. 1 to 4, the operation of the memory device 100 is described below.
(1) The memory device 100 may operate by receiving the chip selection signal CS and the command address signals CA<0:N> using the sync-on internal clock signal ICLK in the sync-on state.
(2) Clock frequency settings may change during the operation of the memory device 100. That is, operating frequency settings of the mode register set circuit 140 may change according to the control of the command decoder 130. In addition, the setting decoder circuit 150 may generate the buffer setting information BUF_SET_P<0:k> according to the changed frequency setting information FSP of the mode register set circuit 140.
(3) The memory device 100 may change from the sync-on state to the sync-off state, and accordingly, the buffer setting information BUF_SET_P<0:k> may be inputted and stored into the buffer setting storage circuit 160. This may represent that the buffer setting information BUF_SET_P<0:k> is applied to the command address buffer circuits 110_0 to 110_N.
(4) The memory controller may change the frequencies of the clock signals CLK_t and CLK_c applied to the memory device 100 and may activate the chip selection signal CS for the sync-on operation.
(5) The phase detection circuit 230 of the internal clock generation circuit 180 may detect which clock signal synchronizes with the chip selection signal CS, among the divided clock signal DIV_CLK and the inverted divided clock signal DIV_CLKB, and may select one of the divided clock signal DIV_CLK and the inverted divided clock signal DIV_CLKB as the sync-on internal clock signal ICLK based on the detection result.
(6) The memory device 100 may operate by receiving the command address signals CA<0:N> in synchronization with the internal clock signal ICLK.

Although according to the embodiments, the process of changing the settings of the command address buffer circuits 110_0 to 110_N in the memory device 100 is described, it is obvious that the above-described embodiments may be applied to other types of buffer circuits of the memory device 100 and buffer circuits of other types of integrated circuit devices other than the memory device 100.

Although the technical spirit of the present disclosure has been described above according to embodiments, this is only for explaining the embodiments according to the concept of the present disclosure, and the present disclosure is not limited to the above embodiments. Various embodiments may be applied by those skilled in the art, to which the present disclosure pertains, within the scope of the technical spirit of the present disclosure.

## Claims

1. An integrated circuit device comprising:
one or more input terminals;
a buffer setting storage circuit configured to receive and store buffer setting information in response to a clock sync state signal; and
one or more buffer circuits configured to be set based on the buffer setting information stored in the buffer setting storage circuit and configured to receive signals of the one or more input terminals, respectively.

2. The integrated circuit device of claim 1, wherein the buffer setting storage circuit is configured to receive and store the buffer setting information in response to the clock sync state signal transitioning from a sync-on state to a sync-off state.

3. The integrated circuit device of claim 2, further comprising:
a setting decoder circuit configured to generate the buffer setting information according to frequency setting information; and
a sync state signal generation circuit configured to change the clock sync state signal to a first level indicating the sync-off state in response to an activation of a sync-off signal and configured to change the clock sync state signal to a second level indicating the sync-on state in response to an activation of a sync-on signal.

4. The integrated circuit device of claim 3, wherein the sync-off signal is activated when one or more of a clock sync-off and a frequency change is instructed.

5. The integrated circuit device of claim 2, wherein the integrated circuit device is a memory device, and
wherein the one or more input terminals are one or more command address input terminals.

6. The integrated circuit device of claim 5, further comprising:
an internal clock generation circuit configured to divide an inputted clock signal and generate a sync-on internal clock signal;
one or more latch circuits configured to latch a command address signal received by the one or more buffer circuits in synchronization with the sync-on internal clock signal; and
a command decoder configured to decode the command address signal stored in the one or more latch circuits.

7. An operating method of an integrated circuit device, the operating method comprising:
changing clock frequency setting information;
decoding the clock frequency setting information and generating buffer setting information;
transitioning from a clock sync-on state to a clock sync-off state; and
applying the buffer setting information to one or more buffer circuits in response to the transitioning.

8. The operating method of claim 7, wherein the integrated circuit device is a memory device, and
wherein the one or more buffer circuits receive one or more command address signals.

9. The operating method of claim 8, further comprising:
transitioning from the clock sync-off state to the clock sync-on state;
dividing an inputted clock signal and generating a sync-on internal clock signal;
receiving, by the one or more buffer circuits, the one or more command address signals in synchronization with the sync-on internal clock signal; and
decoding the one or more command address signals.

10. The operating method of claim 9, wherein the generating of the sync-on internal clock signal includes:
dividing the inputted clock signal and generating a divided clock signal and an inverted divided clock signal; and
selecting one of the divided clock signal and the inverted divided clock signal as the sync-on internal clock signal according to sync-on information.
